# EUROPÄISCHE PATENTSCHRIFT

(11) **EP 1 367 595 B1**
(45) Veröffentlichungstag und Bekanntmachung des Hinweises auf die Patenterteilung: **28.02.2007**
(21) Anmeldenummer: 03007525.3
(22) Anmeldetag: 01.04.2003
(51) Int. Cl.: G11C 16/06, G11C 5/14

(54) **EEPROM und Programmier- und Löschverfahren für ein EEPROM**
EEPROM and method for programming and erasing of an EEPROM
Mémoire EEPROM et procédé programmation et d'effacement d'une mémoire EEPROM

(30) Priorität: 27.05.2002 DE 10223608
(43) Veröffentlichungstag der Anmeldung: 03.12.2003
(73) Patentinhaber: Valeo Schalter und Sensoren GmbH, 74321 Bietigheim-Bissingen (DE)
(72) Erfinder: Lill Anton, D-74348 Lauffen (DE); Hoffsommer Klaus, D-74321 Bietigheim-Bissingen (DE)
(74) Vertreter: Dreiss, Fuhlendorf, Steimle & Becker

(56) Entgegenhaltungen:
- US-A- 4 975 883
- PATENT ABSTRACTS OF JAPAN vol. 016, no. 260 (P-1369), 12. Juni 1992 (1992-06-12) -& JP 04 061695 A (SANYO ELECTRIC CO LTD;OTHERS: 01), 27. Februar 1992 (1992-02-27)
- PATENT ABSTRACTS OF JAPAN vol. 004, no. 168 (P-037), 20. November 1980 (1980-11-20) -& JP 55 113189 A (TOSHIBA CORP), 1. September 1980 (1980-09-01)
- PATENT ABSTRACTS OF JAPAN vol. 005, no. 099 (E-063), 26. Juni 1981 (1981-06-26) & JP 56 042365 A (SEIKO EPSON CORP), 20. April 1981 (1981-04-20)
- PATENT ABSTRACTS OF JAPAN vol. 016, no. 418 (P-1413), 3. September 1992 (1992-09-03) & JP 04 139698 A (SANYO ELECTRIC CO LTD), 13. Mai 1992 (1992-05-13)

## Beschreibung

Die vorliegende Erfindung betrifft ein Programmier- und Löschverfahren für ein EEPROM mit einem Betriebsspannungseingang, das eine Betriebsspannung und eine von der Betriebsspannung verschiedene Programmierspannung aufweist, die zum Betrieb bzw. zum Programmieren des EEPROMs an den Betriebsspannungseingang angelegt werden, und das in eine Schaltung mit mindestens einem Signaleingang integriert ist.

Die vorliegende Erfindung betrifft ferner ein EEPROM mit einem Betriebsspannungseingang, das eine Betriebsspannung und eine von der Betriebsspannung verschiedene Programmierspannung aufweist, die zum Betrieb bzw. zum Programmieren des EEPROMs an den Betriebsspannungseingang angelegt werden, und das in eine Schaltung mit mindestens einem Signaleingang integriert ist.

Obwohl heutzutage EEPROM-Speicherbausteine auf dem Markt sind, die eine interne Ladungspumpe oder eine vergleichbare Spannungsvervielfachungsschaltung zur internen Erzeugung einer Programmierspannung aufweisen, sind vielfach auch noch EEPROM-Speicherbausteine im Einsatz, die keine eigene Ladungspumpe oder Spannungsvervielfachungsschaltung aufweisen und daher auf eine extern anlegbare Programmierspannung angewiesen sind. Gängige Typen dieser EEPROMs besitzen keinen separaten Programmierspannungseingang, so dass zum Programmieren des EEPROMs eine an dem Betriebsspannungseingang des EEPROMs anliegende Betriebsspannung auf den Wert der erforderlichen Programmierspannung erhöht werden muss, um das EEPROM programmieren zu können.

Aufgrund externer Schutzbeschaltung sowie anderer Komponenten, die sich mit dem EEPROM-Baustein im Schaltungsverbund befinden, ist es oft nicht möglich, die an dem Betriebsspannungseingang anliegende Versorgungsspannung des EEPROMs beliebig schnell auf den Wert der Programmierspannung zu erhöhen bzw. umgekehrt eine an dem Betriebsspannungseingang des EEPROMs anliegende Programmierspannung auf den Wert der Versorgungsspannung abzusenken. Insbesondere bei der Massenproduktion von mit EEPROMs ausgestatteten Geräten, die innerhalb der Produktion bereits ein erstes Programmieren der EEPROMs erfordern, ist es sehr unwirtschaftlich, für den Übergang der Versorgungsspannung zur Programmierspannung entsprechende Wartezeiten vorzusehen.

Demgemäß ist es Aufgabe der vorliegenden Erfindung, das eingangs genannte Programmier- und Löschverfahren für ein EEPROM sowie das EEPROM unter Vermeidung der Nachteile des Standes der Technik dahingehend zu verbessern, dass die Wartezeit beim Programmieren des EEPROMs verkürzt wird.

Die Druckschrift JP 55-113189 zeigt eine Tragevorrichtung für eine Datenspeichereinheit. Eine Spannungsversorgung ist hierbei mit der Tragevorrichtung über Verbindungselemente verbunden. Eine Spannung wird über die Tragevorrichtung an die Datenspeichereinheit angelegt.

Die Druckschrift JP 56-42365 zeigt eine Halbleitervorrichtung mit einer Speichereinheit, wobei die Halbleitervorrichtung mit einer Solarzelle ausgestattet ist, so dass die Speichereinheit sowohl durch Sonnenenergie als auch durch eine an der Halbleitervorrichtung angeschlossenen Stromquelle mit Energie versorgt werden kann.

Die Druckschrift US 4 975 883 zeigt ein Verfahren und eine Einrichtung um ein Löschen einer nichtflüchtigen Speichereinheit zu verhindern. Dabei können der Speichereinheit über einen ersten Eingang eine Programmspannung VPP und über einen zweiten separaten Eingang eine Stromkreisspannung VCC bereitgestellt werden. Diesem zweiten Eingang, der der Stromkreisspannung VCC vorbehalten ist, ist ein Inverter vorgeschaltet. Dem Eingang, der für die Programmierspannung VPP vorgesehen ist, ist ein NOR-Gatter vorgeschaltet.

Die Druckschrift JP 4-61695, auf der die Präambel von Ansprüchen 1 und 4 beruht, offenbart einen Schaltkreis der unter beschaltender Kontrolle einer Schaltvorrichtung über einen Programmterminal VPP/VCC eine Speichereinrichtung mit einer Spannung versorgt. Dabei ist ein Eingang einer logischen Spannung VCC mit dem Programmterminal VPP/VCC über eine Diode verbunden. Diese Diode ist dazu vorgesehen, den Programmterminal VPP/VCC vor Gegenströmen zu schützen. Ein Eingang für eine Programmspannung VPP ist ebenfalls mit dem Programmterminal VPP/VCC über einen Schalttransistor des PNP-Typs verbunden. Eine Basis dieses ersten Schalttransistors ist über einen ersten Widerstand mit dem Eingang der Programmspannung VPP verbunden und über einen zweiten Widerstand und einen zweiten Schalttransistor des NPN-Typs geerdet.

Diese Aufgabe wird bei einem Programmier- und Löschverfahren für ein EEPROM der eingangs genannten Art durch die Merkmale der Ansprüche 1 und 4 gelöst. Zum Programmieren des EEPROMs wird die Programmierspannung über den Signaleingang der Schaltung direkt an dem Betriebsspannungseingang des EEPROMs angelegt.

Eine gegebenenfalls zwischen dem Signaleingang und dem Betriebsspannungseingang des EEPROMs befindliche Schutzbeschaltung hat üblicherweise allenfalls eine sehr geringe Laufzeit, die sich in den häufigsten Fällen lediglich durch parasitäre Elemente ergibt, wohingegen eine dem Betriebsspannungseingang des EEPROMs vorangestellte Schaltung oft eine größere Laufzeit aufweist.

Dies gilt insbesondere im Falle eines dem Betriebsspannungseingang vorgeschalteten elektrischen Netzwerks, das den Betriebsspannungseingang mit einer Versorgungsspannung verbindet und eine Laufzeit bezüglich einer Änderung der Versorgungsspannung aufweist, die größer ist als eine vorgegebene maximale Laufzeit. Die große Laufzeit im Falle des elektrischen Netzwerks rührt daher, dass das elektrische Netzwerk hochkapazitive Pufferkondensatoren oder auch Längswiderstände enthalten kann, um die Energieversorgung der Schaltung bei kurzfristigen Einbrüchen der Versorgungsspannung sicherzustellen bzw. eine Strombegrenzung eines in die Schaltung fließenden Stromes zu bewirken.

Im Allgemeinen ist die Laufzeit zwischen dem Signaleingang und dem Betriebsspannungseingang des EEPROMs also viel geringer als die Laufzeit, die sich durch das elektrische Netzwerk ergibt. Somit stellt sich eine an dem Signaleingang angelegte Spannungsänderung sehr viel schneller am Betriebsspannungseingang des EEPROMs ein als eine an dem Eingang des elektrischen Netzwerks angelegte Spannungsänderung.

Hierdurch ist es nicht mehr erforderlich, z.B. während der Produktion von mit EEPROMs ausgestatteten Geräten eine Wartezeit zwischen dem Anlegen der Versorgungsspannung und dem Anlegen der Programmierspannung an ein EEPROM vorzusehen, wodurch die Wirtschaftlichkeit des entsprechenden Produktionsschritts deutlich gesteigert wird.

Eine ganz besonders vorteilhafte Ausführungsform des erfindungsgemäßen Verfahrens ist dadurch gekennzeichnet, dass das Programmieren des EEPROMs nur dann erlaubt wird, wenn an dem Versorgungsspannungseingang die Betriebsspannung anliegt, und wenn an dem Signaleingang die Programmierspannung anliegt.

Diese Kombination von an der Schaltung anliegenden Spannungen liegt im Normalbetrieb nicht vor, da der Signaleingang normalerweise anderweitig verwendet wird, beispielsweise zur seriellen Übertragung von Daten zu der Schaltung.

Eine über der Versorgungsspannung liegende Programmierspannung liegt an dem Signaleingang nur dann an, wenn die Schaltung mit einer speziellen Kalibriereinrichtung verbunden ist, die die Programmierspannung erzeugen kann.

Als eine weitere Lösung der Aufgabe der vorliegenden Erfindung ist bei einem EEPROM der eingangs genannten Art vorgesehen, dass zum Programmieren des EEPROMs die Programmierspannung über den Signaleingang der Schaltung direkt an dem Betriebsspannungseingang des EEPROMs angelegt werden kann.

Eine weitere sehr vorteilhafte Ausführungsform der vorliegenden Erfindung sieht vor, dass der Signaleingang direkt mit dem Betriebsspannungseingang verbunden ist.

Bei einer weiteren Ausführungsform der Erfindung ist der Signaleingang mit einem Programmierspannungseingang des EEPROMs verbunden.

Eine weitere, ebenfalls sehr vorteilhafte Ausführungsform der Erfindung ist dadurch gekennzeichnet, dass zwischen dem Signaleingang und dem Betriebsspannungseingang des EEPROMs und/oder zwischen dem Netzwerk und dem Betriebsspannungseingang des EEPROMs jeweils eine Diode vorgesehen ist, deren Kathode mit dem Betriebsspannungseingang verbunden ist.

Diese Dioden stellen sicher, dass ein Stromfluss innerhalb der Schaltung nur in der jeweils gewünschten Richtung stattfindet, auch wenn sich aufgrund des Anlegens der Programmierspannung an den Signaleingang eine Potentialdifferenz zwischen dem Betriebsspannungseingang des EEPROMs und dem Ausgang des elektrischen Netzwerks ergibt, die einen Stromfluss vom Betriebsspannungseingang des EEPROMs in Richtung der Versorgungsspannungsquelle zur Folge hätte.

Weitere Merkmale, Anwendungsmöglichkeiten und Vorteile der Erfindung ergeben sich aus der nachfolgenden Beschreibung von Ausführungsbeispielen der Erfindung, die in der Figur der Zeichnung dargestellt sind.

In der Zeichnung zeigt:

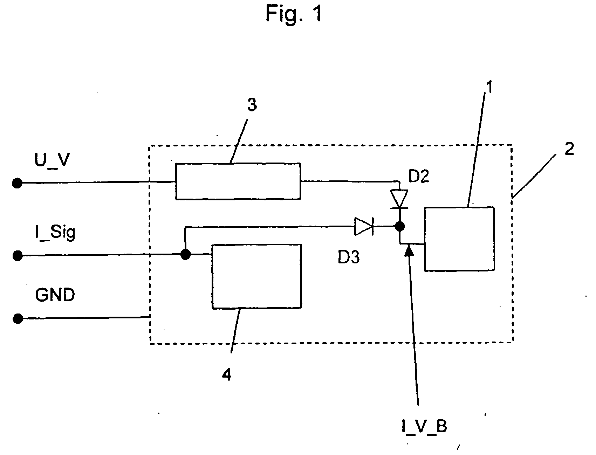

- Fig. 1:: eine erste Ausführungsform der Erfindung mit einem EEPROM 1, das in eine Schaltung 2 integriert ist.

Das in Fig. 1 dargestellte EEPROM 1 ist in eine Schaltung 2 integriert, die drei elektrische Anschlüsse aufweist, nämlich einen Versorgungsspannungseingang U_V, einen Signaleingang I_Sig und einen Masseanschluss GND.

Dem Versorgungsspannungseingang U_V ist innerhalb der Schaltung 2 ein elektrisches Netzwerk 3 nachgeordnet, dessen Ausgang mit dem Betriebsspannungseingang I_V_B des EEPROMs 1 verbunden ist. Das elektrische Netzwerk 3 weist eine in Fig. 1 nicht dargestellte Schutzbeschaltung auf, die einen hochkapazitiven Pufferkondensator, eine Schutzdiode und einen Längswiderstand besitzt.

Der hochkapazitive Pufferkondensator dient dazu, kurzzeitige Einbrüche in der Versorgungsspannung U_V auszugleichen und wird über den Längswiderstand aufgeladen, mit dem er zusammen einen Tiefpass bildet. Die Schutzdiode ist in Reihe zu dem Längswiderstand geschaltet und verhindert eine Zerstörung der Schaltung 2 durch falsche Polung der elektrischen Anschlüsse.

Die in dem elektrischen Netzwerk 3 enthaltene Schutzbeschaltung bewirkt eine große Laufzeit t elektrischer Signale durch das Netzwerk 3. So wirkt sich eine Erhöhung der an dem elektrischen Netzwerk 3 anliegenden Versorgungsspannung U_V zur Programmierspannung V_Prog zum Programmieren des EEPROMs 1 erst nach der Laufzeit t an dem Betriebsspannungseingang I_V_B des EEPROMs 1 aus.

Die Laufzeit t ist i.a. größer als eine vorgegebene maximal zulässige Laufzeit tₘₐₓ und ist daher insbesondere bei der Massenproduktion der Schaltung 2 unerwünscht, so dass die Programmierspannung V_Prog über den Signaleingang I_Sig der Schaltung 2 an den Betriebsspannungseingang I_V_B des EEPROMs 1 angelegt wird.

Der Signaleingang I_Sig ist mit der ebenfalls in der Schaltung 2 angeordneten Schaltgruppe 4 verbunden, die eine serielle Kommunikation der Schaltung 2 mit anderen, nicht in Figur 1 abgebildeten Schaltungen ermöglicht.

Im Normalbetrieb der Schaltung 2, d.h. wenn das EEPROM 1 nicht programmiert wird, wird der Signaleingang I_Sig wie beschrieben zur seriellen Kommunikation benutzt.

Sobald jedoch das EEPROM 1 programmiert werden muss, wird die Programmierspannung V_Prog an den Signaleingang I_Sig angelegt. Da der Signaleingang I_Sig sowie eine ggf. zwischen dem Signaleingang I_Sig und dem Betriebsspannungseingang I_V_B des EEPROMs 1 vorhandene Beschaltung eine weitaus geringere Laufzeit als die Laufzeit t des elektrischen Netzwerks 3 aufweist, ist nahezu keine Wartezeit erforderlich, bis die Programmierspannung V_Prog auch an dem Betriebsspannungseingang I_V_B des EEPROMs 1 anliegt.

Die Diode D2 verhindert hierbei einen Stromfluss von dem Signaleingang I_Sig in das elektrische Netzwerk 3, der sich aufgrund der Potentialdifferenz zwischen dem Signaleingang I_Sig und der Betriebsspannung V_B beim Anlegen der Programmierspannung V_Prog an dem Signaleingang I_Sig ergeben würde.

Analog verhindert die Diode D3 einen Stromfluss von dem Betriebsspannungseingang I_V_B zu dem Signaleingang I_Sig, der sich im Normalbetrieb ergeben würde, sobald der Signaleingang I_Sig ein niedrigeres Potential als das der Betriebsspannung V_B entsprechende Potential annimmt.

Ein Schutz vor unerwünschtem Programmieren des EEPROMs 1 ergibt sich dadurch, dass die Programmierung nur dann erlaubt wird, wenn die Betriebsspannung V_B an dem Verorgungsspannungseingang U_V der Schaltung 2 anliegt, und wenn gleichzeitig die Programmierspannung V_Prog an dem Signaleingang I_Sig anliegt.

Diese Kombination ergibt sich im Normalbetrieb der Schaltung 2 nicht, und sie kann durch eine einfache Logikschaltung (nicht gezeigt) erkannt werden, woraufhin die Programmierung des EEPROMs 1 entsprechend erlaubt oder verboten werden kann.

Anstelle des Signaleingangs I_Sig kann zum Anlegen der Programmierspannung V_Prog auch jeder andere Eingang der Schaltung 2 verwendet werden, der nicht zum Betrieb der Schaltung 2 benötigt wird, solange das EEPROM 1 programmiert wird.

Bei EEPROMs mit separatem Programmierspannungseingang kann der Signaleingang I_Sig auch direkt mit dem Programmierspannungseingang verbunden werden.

Das erfindungsgemäße Verfahren ist auch sehr zweckmäßig, wenn das elektrische Netzwerk 3 keinen Längswiderstand besitzt und die nachfolgende Schaltung nur eine sehr geringe Stromaufnahme aufweist. In diesem Fall wird eine Spannungserhöhung zwar sofort erfolgen, aber eine Spannungsverringerung, wie sie z.B. bei einem Wechsel von der Programmierspannung zur Betriebsspannung erforderlich ist, erfordert je nach Stromaufnahme der Schaltung und Kapazität des Pufferkondensators eine Wartezeit, während der der Pufferkondensator entladen wird. Diese Wartezeit kann mit dem vorliegenden Verfahren umgangen werden.

Ferner ist das vorliegende Verfahren nicht nur bei EEPROMS anwendbar, sondern auch bei EPROMs und PROMs sowie ganz allgemein bei Halbeleiterbausteinen und -speichern, die eine Programmierspannung benötigen.

## Patentansprüche

1. Programmier- und Löschverfahren für ein EEPROM (1) mit einem Betriebsspannungseingang (I_V_B), das eine Betriebsspannung (V_B) und eine von der Betriebsspannung (V_B) verschiedene Programmierspannung (V_Prog) aufweist, die zum Betrieb bzw. zum Programmieren des EEPROMs (1) an den Betriebsspannungseingang (I_V_B) angelegt werden, und das in eine Schaltung (2) mit mindestens einem Signaleingang (I_Sig) integriert ist, wobei zum Programmieren des EEPROMs (1) die Programmierspannung (V_Prog) über den Signaleingang (I_Sig) der Schaltung (2) an den Betriebsspannungseingang (I_V_B) des EEPROMs (1) angelegt wird,
**dadurch gekennzeichnet,**
**dass** zwischen dem Signaleingang (I_Sig) und dem Betriebsspannungseingang (I_V_B) des EEPROMs (1) eine Diode (D3) vorgesehen ist, deren Kathode mit dem Betriebsspannungseingang (I_V_B) verbunden ist,
und **dass** der Signaleingang (I_Sig) mit einer Schaltgruppe (4) zur seriellen Kommunikation der Schaltung (2), wenn das EEPROM (1) nicht programmiert wird, mit anderen Schaltgruppen verbunden ist.

2. Verfahren nach Anspruch 1, wobei dem EEPROM (1) ein seinem Betriebsspannungseingang (I_V_B) vorgeschaltetes elektrisches Netzwerk (3) zugeordnet ist, das den Betriebsspannungseingang (I_V_B) mit einer Versorgungsspannung (U_V) verbindet und eine Laufzeit (t) bezüglich einer Änderung der Versorgungsspannung (U_V) aufweist, die größer ist als eine vorgegebene maximale Laufzeit (tₘₐₓ)

3. Verfahren nach Anspruch 1 oder 2, **dadurch gekennzeichnet, dass** das Programmieren des EEPROMs (1) nur dann erlaubt wird, wenn an einem Versorgungsspannungseingang (U_V) die Betriebsspannung (V_B) anliegt und wenn an dem Signaleingang (I_Sig) die Programmierspannung (V_Prog) anliegt.

4. Schaltung (2) mit mindestens einem Signaleingang (I_Sig) und einem integrierten EEPROM (1) mit einem Betriebsspannungseingang (I_V_B), das eine Betriebsspannung (V_B) und eine von der Betriebsspannung (V_B) verschiedene Programmierspannung (V_Prog) aufweist, die zum Betrieb bzw. zum Programmieren des EEPROMs (1) an den Betriebsspannungseingang (I_V_B) angelegt werden, wobei zum Programmieren des EEPROMs (1) die Programmierspannung (V_Prog) über den Signaleingang (I_Sig) der Schaltung (2) an den Betriebsspannungseingang (I_V_B) des EEPROMs (1) angelegt werden kann,
**dadurch gekennzeichnet,**
**dass** zwischen dem Signaleingang (I_Sig) und dem Betriebsspannungseingang (I_V_B) des EEPROMs (1) eine Diode (D3) vorgesehen ist, deren Kathode mit dem Betriebsspannungseingang (I_V_B) verbunden ist,
und **dass** der Signaleingang (I_Sig) mit einer Schaltgruppe (4) zur seriellen Kommunikation der Schaltung (2), wenn das EEPROM (1) nicht programmiert wird, mit anderen Schaltgruppen verbunden ist.

5. Schaltung (2) nach Anspruch 4, wobei dem EEPROM (1) ein seinem Betriebsspannungseingang (I_V_B) vorgeschaltetes elektrisches Netzwerk (3) zugeordnet ist, das den Betriebsspannungseingang (I_V_B) mit einer Versorgungsspannung (U_V) verbindet und eine Laufzeit (t) bezüglich einer Änderung der Versorgungsspannung (U_V) aufweist, die größer ist als eine vorgegebene maximale Laufzeit (tₘₐₓ).

6. Schaltung (2) nach Anspruch 4 oder 5, **dadurch gekennzeichnet, dass** der Signaleingang (I_Sig) direkt mit dem Betriebsspannungseingang (I_V_B) verbunden ist.

7. Schaltung (2) nach einem der Ansprüche 4 bis 6, **dadurch gekennzeichnet, dass** der Signaleingang (I_Sig) mit einem Programmierspannungseingang des EEPROMs (1) verbunden ist.

8. Schaltung (2) nach einem der Ansprüche 4 bis 7 , **dadurch gekennzeichnet, dass** zwischen dem Netzwerk (3) und dem Betriebsspannungseingang (I_V_B) des EEPROMs (1) eine Diode (D2) vorgesehen ist, deren Kathode mit dem Betriebsspannungseingang (I_V_B) verbunden ist.

## Claims

1. Programming and erasing method for an EEPROM (1) having an operating voltage input (I_V_B), which has an operating voltage (V_B) and a programming voltage (V_Prog) which is different from the operating voltage (V_B), which are applied to the operating voltage input (I_V_B), respectively, for operating and programming the EEPROM (1), and which is integrated into a circuit (2) with at least one signal input (I_Sig), wherein for programming the EEPROM (1) the programming voltage (V_Prog) can be applied via the signal input (I_Sig) of the circuit (2) to the operating voltage input (I_V_B) of the EEPROM (1), **characterised in that** between the signal input (I_Sig) and the operating voltage input (I_V_B) of the EEPROM (1) a diode (D3) is provided whose cathode is connected to the operating voltage input (I_V_B), and that the signal input (I_Sig) is connected to a switching group (4) for serial communication of the circuit (2) with other switching groups if the EEPROM (1) is not programmed.

2. Method according to claim 1, wherein an electrical network (3) is assigned to the EEPROM (1), said electrical network being connected upstream of the operating voltage input (I_V_B) of said EEPROM, said network connecting the operating voltage input (I_V_B) to a supply voltage (U_V) and has a transit time (t) with respect to a change in the supply voltage (U_V) which is greater than a predetermined maximum transit time (tₘₐₓ).

3. Method according to claim 1 or 2, **characterised in that** programming of the EEPROM (1) is only allowed if the operating voltage (V_B) is applied at a supply voltage input (U_V) and if the programming voltage (V_Prog) is applied at the signal input (I_Sig).

4. Circuit (2) having at least one signal input (I_Sig) and an integrated EEPROM (1) having an operating voltage input (I_V_B), which has an operating voltage (V_B) and a programming voltage (V_Prog) which is different from the operating voltage (V_B), which are applied to the operating voltage input (I_V_B), respectively, for operating and programming the EEPROM (1), wherein for programming the EEPROM (1) the programming voltage (V_Prog) can be applied via the signal input (I_Sig) of the circuit (2) to the operating voltage input (I_V_B) of the EEPROM (1), **characterised in that** between the signal input (I_Sig) and the operating voltage input (I_V_B) of the EEPROM (1) a diode (D3) is provided whose cathode is connected to the operating voltage input (I_V_B), and that the signal input (I_Sig) is connected to a switching group (4) for serial communication of the circuit (2) with other switching groups if the EEPROM (1) is not programmed.

5. Circuit (2) according to claim 4, wherein an electrical network (3) is assigned to the EEPROM (1), said electrical network being connected upstream of the operating voltage input (I_V_B) of said EEPROM, said network connecting the operating voltage input (I_V_B) to a supply voltage (U_V) and has a transit time (t) with respect to a change in the supply voltage (U_V) which is greater than a predetermined maximum transit time (tₘₐₓ).

6. Circuit (2) according to claim 4 or 5, **characterised in that** the signal input (I_Sig) is linked directly to the operating voltage input (I_V_B).

7. Circuit (2) according to one of the claims 4 to 6, **characterised in that** the signal input (I_Sig) is connected to a programming voltage input of the EEPROM (1).

8. Circuit (2) according to one of the claims 4 to 7, **characterised in that** between the network (3) and the operating voltage input (I_V_B) of the EEPROM (1), a diode (D2) is provided whose cathode is connected to the operating voltage input (I_V_B).

## Revendications

1. Procédé de programmation et d'effacement pour une EEPROM (1) avec une entrée de tension de service (I_V_B), qui comporte une tension de service (V_B) et une tension de programmation (V_Prog) différente de la tension de service (V_B) appliquées à l'entrée de tension de service (I_V_B) pour le fonctionnement ou la programmation de l'EEPROM (1), et qui est intégré dans un circuit (2) avec au moins une entrée de signalisation (I_Sig), la tension de programmation (V_Prog) étant appliquée à l'entrée de tension de service (I_V_B) de l'EEPROM (1) via l'entrée de signalisation (I_Sig) du circuit (2) pour programmer l'EEPROM (1),
**caractérisé en ce**
**qu'**on a prévu entre l'entrée de signalisation (I_Sig) et l'entrée de tension de service (I_V_B) de l'EEPROM (1) une diode (D3) dont la cathode est raccordée à l'entrée de tension de service (I_V_B),
et en ce que l'entrée de signalisation (I_Sig) est reliée à une partie commutation (4) pour la communication série du circuit (2) avec d'autres parties commutation lorsque l'EEPROM (1) n'est pas programmée.

2. Procédé selon la revendication 1, à l'EEPROM (1) étant affecté un réseau électrique (3), branché en amont de son entrée de tension de service (I_V_B) qui relie l'entrée de tension de service (I_V_B) avec la tension d'alimentation (U_V) et comporte un temps d'exécution (t) supérieur à un temps d'exécution maximal (tₘₐₓ) prédéfini pour la modification de la tension d'alimentation (U_V).

3. Procédé selon l'une quelconque des revendications 1 ou 2, **caractérisé en ce que** la programmation de l'EEPROM (1) n'est autorisée que lorsque la tension de service (V_B) est appliquée à une entrée de tension d'alimentation (U_V) et que la tension de programmation (V_Prog) est appliquée à l'entrée de signalisation (I_Sig).

4. Circuit (2) avec au moins une entrée de signalisation (I_Sig) et une EEPROM (1) intégrée avec une entrée de tension de service (I_V_B) qui présente une tension de service (V_B) et une tension de programmation (V_Prog) différente de la tension de service (V_B) appliquées à l'entrée de tension de service (I_V_B) pour le fonctionnement ou la programmation de l'EEPROM (1), la tension de programmation (V_Prog) pouvant être appliquée à l'entrée de tension de service (I_V_B) de l'EEPROM (1) via l'entrée de signalisation (I_Sig) du circuit (2) pour la programmation de l'EEPROM (1),
**caractérisé en ce**
**qu'**on a prévu entre l'entrée de signalisation (I_Sig) et l'entrée de tension de service (I_V_B) de l'EEPROM (1) une diode (D3) dont la cathode est raccordée à l'entrée de tension de service (I_V_B),
et en ce que l'entrée de signalisation (I_Sig) est reliée à une partie commutation (4) pour la communication série du circuit (2) avec d'autres parties commutation lorsque l'EEPROM (1) n'est pas programmée.

5. Circuit (2) selon la revendication 4, à l'EEPROM (1) étant affecté un réseau électrique (3), branché en amont de son entrée de tension de service (I_V_B), qui relie l'entrée de tension de service (I_V_B) avec la tension d'alimentation (U_V) et comporte un temps d'exécution (t) supérieur à un temps d'exécution maximal (tₘₐₓ) prédéfini pour la modification de la tension d'alimentation (U_V).

6. Circuit (2) selon l'une quelconque des revendications 4 ou 5, **caractérisé en ce que** l'entrée de signalisation (I_Sig) est directement reliée à l'entrée de tension de service (I_V_B).

7. Circuit (2) selon l'une quelconque des revendications 4 à 6, **caractérisé en ce que** l'entrée de signalisation (I_Sig) est reliée à une entrée de tension de programmation de l'EEPROM (1).

8. Circuit (2) selon l'une quelconque des revendications 4 à 7, **caractérisé en ce qu'**entre le réseau (3) et l'entrée de tension de service (I_V_B) de l'EEPROM (1) est prévue une diode (D2) dont la cathode est reliée à l'entrée de tension de service (I_V_B).
